# EUROPEAN PATENT APPLICATION

(11) **EP 4 822 745 A1**
(43) Date of publication of application: **14.10.2026**
(21) Application number: 24899629.0
(22) Date of filing: 21.11.2024
(51) Int. Cl.: H01L 23/48, H02M 1/00

(54) **ELECTRONIC DEVICE MODULE, CONTROLLER, AND VEHICLE**

(30) Priority: 08.12.2023 CN 202311689423
(71) Applicant: BYD Company Limited, Shenzhen, Guangdong 518118 (CN)
(72) Inventor: LING, Heping, Shenzhen, Guangdong 518118 (CN); ZHAI, Zhen, Shenzhen, Guangdong 518118 (CN); LIU, Haijun, Shenzhen, Guangdong 518118 (CN); HUANG, Dandan, Shenzhen, Guangdong 518118 (CN); TANG, Chengbo, Shenzhen, Guangdong 518118 (CN)
(74) Representative: Mathys & Squire
(86) International application number: PCT/CN2024/133519
(87) International publication number: WO 2025/118988

(57) **Abstract**

A vehicle includes a controller, and the controller includes an electronic device module. The electronic device module includes two functional modules. Each of the functional modules is provided with a first terminal and a second terminal. The first terminal and the second terminal both extend toward the other functional module. End portions of the two first terminals are electrically connected, and end portions of the two second terminals are electrically connected. In a thickness direction of the first terminal, a projection of the second terminal onto the first terminal is at least partially accommodated within the first terminal.

## Description

This application claims priority to Chinese Patent Application No. 202311689423.4, filed with the Chinese Patent Office on December 8, 2023 and entitled "ELECTRONIC DEVICE MODULE, CONTROLLER, AND VEHICLE", which is incorporated herein by reference in its entirety.

### TECHNICAL FIELD

The present disclosure relates to the field of electronic device modules, and in particular, to an electronic device module, a controller including the electronic device module, and a vehicle including the controller.

### BACKGROUND

A vehicle controller usually includes a DC-link capacitor and a power module that are electrically connected to each other. In conventional technologies, a terminal of the DC-link capacitor is usually electrically connected to a terminal of the power module by means of a nut.

However, limited by the required terminal extension length for the nut connection, longer terminals increase the inductance loop between the DC-link capacitor and the power module. Meanwhile, due to poor reliability of the nut connection, loosening of the nut may create a gap between the two connected terminals, which further increases stray inductance. High stray inductance may cause significant oscillations in a circuit system, resulting in problems such as energy attenuation and device damage.

### SUMMARY

In view of the foregoing shortcomings of the conventional technologies, the present disclosure aims to provide an electronic device module configured to reduce stray inductance, a controller including the electronic device module, and a vehicle including the controller. Specifically, the following technical solutions are included.

According to a first aspect, an embodiment of the present disclosure provides an electronic device module, including two functional modules. Each of the functional modules is provided with a first terminal and a second terminal. The first terminal and the second terminal both extend toward the other functional module. End portions of the first terminals of the two functional modules are electrically connected, and end portions of the second terminals of the two functional modules are electrically connected. In a thickness direction of the first terminal, a projection of the second terminal onto the first terminal is at least partially accommodated within the first terminal.

According to the electronic device module in the present disclosure, two terminals of the two functional modules are disposed between the two functional modules, and the projection of the second terminal onto the first terminal is at least partially accommodated within the first terminal, so that a magnetic field generated by a current flowing in the two first terminals can at least partially cancel a magnetic field generated by a current flowing to the two second terminals, thereby reducing generation of stray inductance.

In an embodiment, a sum of lengths of the two first terminals of the two functional modules is greater than or equal to a maximum separation distance between the two functional modules, and the end portions of the two first terminals of the two functional modules are electrically connected by lapping.

In an embodiment, a sum of lengths of the two first terminals of the two functional modules is L1, a maximum separation distance between the two functional modules is D1, and a thickness of the first terminal of each of the functional modules is H1, where L1<D1, and D1-L1≤H1/2; and the end portions of the two first terminals of the two functional modules are electrically connected by molten filling.

In an embodiment, the electronic device module further includes a connector. The end portions of the two second terminals of the two functional modules are electrically connected via the connector. The connector includes a connecting portion and two abutment portions. The connecting portion is located between the two abutment portions, and each abutment portion is electrically connected to one of the second terminals.

In an embodiment, a sum of lengths of the connecting portion and the two abutment portions is greater than or equal to a maximum separation distance between the two second terminals of the two functional modules, and each of the abutment portions is electrically connected by lapping to the second terminal of one of the functional modules.

In an embodiment, a sum of lengths of the connecting portion and the two abutment portions is L2, a maximum separation distance between the two second terminals of the two functional modules is D2, and a thickness of the second terminal of each of the functional modules is H2, where L2<D2, and D2-L2<H2/2; and each of the abutment portions is electrically connected by molten filling to the second terminal of one of the functional modules.

In an embodiment, the first terminal of at least one of the functional modules includes a plurality of first sub-terminals, and the first sub-terminals are spaced apart in a width direction of the first terminal; and/or the second terminal of at least one of the functional modules includes a plurality of second sub-terminals, and the second sub-terminals are spaced apart in a width direction of the second terminal.

In an embodiment, the first terminal of at least one of the functional modules includes a plurality of first sub-terminals, and in a width direction of the first terminal, a width of the first sub-terminal located at an edge among the plurality of first sub-terminals is greater than a width of the remaining first sub-terminals.

In an embodiment, for the same functional module, the first terminal includes a plurality of first sub-terminals, the second terminal includes a plurality of second sub-terminals, a quantity of the first sub-terminals is equal to a quantity of the second sub-terminals, and in the thickness direction of the first terminal, a projection of each of the second sub-terminals onto the first sub-terminal is at least partially accommodated within one of the first sub-terminals.

In an embodiment, a ratio of a width of the first terminal to a width of the second terminal is between 0.8 and 1.2.

In an embodiment, the electronic device module further includes two insulating members, each of the insulating members is fastened between the first terminal and the second terminal of one of the functional modules and extends toward the other functional module, and an extension length of each of the insulating members is between an extension length of the first terminal and an extension length of the second terminal.

In an embodiment, the electronic device module further includes a second insulating member, the second insulating member is disposed on a surface of the connector that faces the first terminal, and in the thickness direction of the first terminal, a projection of the second insulating member onto the first terminal covers the first terminal exposed between the two second terminals of the two functional modules; in a length direction of the first terminal, a length of the second insulating member is greater than or equal to a spacing between the two insulating members of the two functional modules; and in a width direction of the first terminal, a width of the second insulating member is greater than or equal to a width of the connector.

In an embodiment, the electronic device module further includes an insulating layer, the insulating layer is coated on a surface of the connector that faces the first terminal, and in the thickness direction of the first terminal, a projection of the first terminal exposed between the two second terminals of the two functional modules onto the insulating layer is accommodated within the insulating layer; and
in a length direction of the first terminal, a length of the insulating layer is greater than or equal to a spacing between the two insulating members of the two functional modules.

In an embodiment, at least one of the insulating members is provided with insulating protrusions, the insulating protrusions are exposed between the second terminals of the two functional modules and extend in a direction away from the first terminal, and the insulating protrusions are spaced apart from the connector.

In an embodiment, at least one groove is provided on a surface of the insulating protrusions that is away from the first terminal; and/or at least one groove is provided on a surface of the insulating protrusions that is away from the second terminal.

In an embodiment, a surface of the insulating protrusions that is away from the first terminal is provided with a positioning post in a protruding manner, and in a width direction of the first terminal, the positioning post is spaced apart from the first terminal and the second terminal; and a positioning hole is provided in the connector, and the positioning post is configured to extend into the positioning hole, to implement positioning of the connector.

In an embodiment, the end portions of the first terminals of the two functional modules are electrically connected by using a non-contact energy source scanning connection technology; and in the thickness direction of the first terminal, a spacing between the end portions of the first terminals of the two functional modules is less than or equal to 0.2 mm.

In an embodiment, the end portion of the second terminal of at least one of the functional modules is electrically connected to the connector by using a non-contact energy source scanning connection technology; and in a thickness direction of the second terminal, a spacing between the end portion of the second terminal that is electrically connected to the connector by using the non-contact energy source scanning connection technology is less than or equal to 0.2 mm.

According to a second aspect, an embodiment of the present disclosure provides a controller, including the electronic device module, and two functional modules of the electronic device module are respectively a DC-link capacitor and a power module.

According to a third aspect, an embodiment of the present disclosure provides a vehicle, including the controller.

It will be understood that the controller provided in the second aspect of the present disclosure and the vehicle provided in the third aspect of the present disclosure both have an effect of reducing stray inductance due to the use of the electronic device module provided in the first aspect of the present disclosure.

### BRIEF DESCRIPTION OF DRAWINGS

FIG. 1 is a diagram of a structure of a vehicle according to an embodiment of the present disclosure;
FIG. 2 is a diagram of a structure of an electronic device module according to an embodiment of the present disclosure;
FIG. 3 is a diagram of a structure of a first functional module of an electronic device module according to an embodiment of the present disclosure;
FIG. 4 is a diagram of a structure of a second functional module of an electronic device module according to an embodiment of the present disclosure;
FIG. 5 is a diagram of a front view structure of an electronic device module according to an embodiment of the present disclosure;
FIG. 6 is an enlarged diagram of an electronic device module according to an embodiment of the present disclosure;
FIG. 7 is another enlarged diagram of an electronic device module according to an embodiment of the present disclosure;
FIG. 8 is still another enlarged diagram of an electronic device module according to an embodiment of the present disclosure;
FIG. 9 is a diagram of a structure of a connector according to an embodiment of the present disclosure;
FIG. 10 is a partially enlarged diagram of an electronic device module according to an embodiment of the present disclosure;
FIG. 11 is another partially enlarged diagram of an electronic device module according to an embodiment of the present disclosure;
FIG. 12 is an enlarged diagram of a first functional module of an electronic device module according to an embodiment of the present disclosure;
FIG. 13 is an enlarged diagram of a second functional module of an electronic device module according to an embodiment of the present disclosure;
FIG. 14 is still another partially enlarged diagram of an electronic device module according to an embodiment of the present disclosure; and
FIG. 15 is another enlarged diagram of a second functional module of an electronic device module according to an embodiment of the present disclosure.

### DESCRIPTION OF EMBODIMENTS

For ease of understanding of the present disclosure, the following describes the present disclosure more comprehensively with reference to related accompanying drawings. Preferred implementations of the present disclosure are illustrated in the accompanying drawings. However, the present disclosure can be implemented in many different forms and is not limited to implementations described in this specification. On the contrary, an objective of providing these implementations is to make the content disclosed in the present disclosure more thoroughly and comprehensively understood.

The following description of embodiments refers to the accompanying drawings to illustrate specific embodiments in which the present disclosure can be implemented. In this specification, the sequence numbers, for example, "first" and "second", of components are merely intended to distinguish between the described objects, and do not have any sequential or technical meaning. Unless otherwise specified, the terms "connection" and "linkage" used in the present disclosure include both direct and indirect connections (linkages). The directional terms mentioned in the present disclosure, for example, "up", "down", "front", "back", "left", "right", "inside", "outside", and "side surface" are merely directions with reference to the accompanying drawings. Therefore, the directional terms are used to better and more clearly describe and understand the present disclosure, instead of indicating or implying that a specified apparatus or element should have a specific orientation, or be constructed and operated in a specific orientation. Therefore, this will not be construed as a limitation on the present disclosure.

In the description of the present disclosure, it will be noted that, unless otherwise expressly specified and limited, terms "mount", "interconnect" and "connect" will be understood in a broad sense. For example, the terms may indicate a fixed connection, a detachable connection, or an integral connection, may indicate a mechanical connection, or may indicate a direct connection, an indirect connection through an intermediate medium, or internal communication between two elements. For a person of ordinary skill in the art, a specific meaning of the foregoing terms in the present disclosure will be understood based on a specific situation. It will be noted that, in the specification, claims, and accompanying drawings of the present disclosure, the terms such as "first" and "second" are intended to distinguish between different objects, but do not indicate a particular order. In addition, the term "comprise" "may comprise" "include", or "may include" used in the present disclosure indicate the presence of a corresponding function, operation, element, or the like disclosed, but do not limit other one or more additional functions, operations, elements, or the like. In addition, the term "comprise" or "include" indicates the presence of a corresponding feature, number, step, operation, element, component, or a combination thereof disclosed in this specification, but does not exclude the presence or addition of one or a plurality of other features, numbers, steps, operations, elements, components, or combinations thereof, and is intended to cover a non-exclusive inclusion.

Unless otherwise defined, all technical and scientific terms used in this specification have the same meaning as those usually understood by a person of ordinary skill in the art of the present disclosure. The terms used in this specification of the present disclosure are merely for the purpose of describing specific implementations, but are not intended to limit the present disclosure.

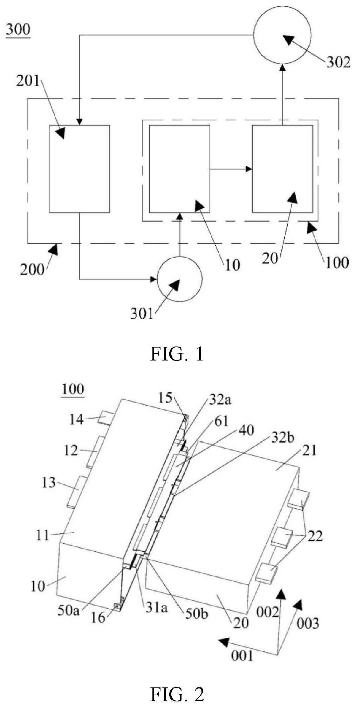

FIG. 1 is a diagram of a structure of a vehicle according to an embodiment of the present disclosure.

As shown in FIG. 1, a vehicle 300 of the present disclosure includes a battery pack 301, a controller 200, and an electric motor 302. The controller 200 is electrically connected between the battery pack 301 and the electric motor 302, to control an output of the electric motor 302 by controlling electrical energy supplied from the battery pack 301 to the electric motor 302.

The controller 200 of the present disclosure includes a control module 201 and an electronic device module 100. The electronic device module 100 includes a first functional module 10 and a second functional module 20 that are electrically connected. The first functional module 10 is a DC-link capacitor, and the second functional module 20 is a power module.

As shown in FIG. 1, when a user inputs a drive signal to the control module 201, the drive signal can be transmitted to the battery pack 301, causing the battery pack 301 to output a current to the first functional module 10. After being processed by the first functional module 10, the current is output to the second functional module 20. The second functional module 20 serving as the power module converts a direct current processed by the first functional module 10 into a three-phase alternating current and transmits the three-phase alternating current to the electric motor 302. The electric motor 302 rotates under an action of the three-phase alternating current and transmits signals such as a rotation speed and a torque of the electric motor 302 to the control module 201. The control module 201 processes the signals and provides feedback to the user.

The first functional module 10 serving as a DC-link capacitor absorbs ripples to implement a function of protecting the electronic device module 100 of the present disclosure, thereby preventing the electronic device module 100 of the present disclosure from breaking down due to a high voltage.

For ease of description, the first functional module 10 of the electronic device module 100 of the present disclosure is a DC-link capacitor, and the second functional module 20 is a power module. It will be understood that, in another embodiment, the first functional module 10 may be a power module and the second functional module 20 may be a DC-link capacitor. In some other embodiments, the first functional module and the second functional module may alternatively be other functional devices. This is not particularly limited in the present disclosure.

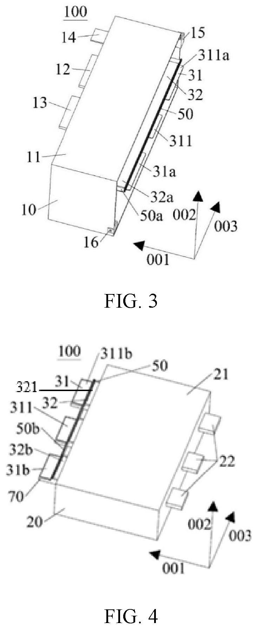

FIG. 2 is a diagram of a structure of an electronic device module according to an embodiment of the present disclosure. FIG. 3 is a diagram of a structure of a first functional module of an electronic device module according to an embodiment of the present disclosure. FIG. 4 is a diagram of a structure of a second functional module of an electronic device module according to an embodiment of the present disclosure.

As shown in FIG. 2 to FIG. 4, the electronic device module 100 of the present disclosure includes the first functional module 10 and the second functional module 20. The first functional module 10 and the second functional module 20 are spaced apart. A surface of the first functional module 10 that faces the second functional module 20 is provided with a first terminal 31 and a second terminal 32 in a protruding manner, and the first terminal 31 and the second terminal 32 both extend toward the second functional module 20. A surface of the second functional module 20 that faces the first functional module 10 is also provided with a first terminal 31 and a second terminal 32 in a protruding manner, and the first terminal 31 and the second terminal 32 both extend toward the first functional module 10.

As shown in FIG. 3, the first functional module 10 includes a first body portion 11, the first terminal 31 disposed in the first functional module 10 is a first capacitor terminal 31a, the second terminal 32 disposed in the first functional module is a second capacitor terminal 32a, and the first capacitor terminal 31a and the second capacitor terminal 32a are both electrically connected to an internal structure of the first body portion 11.

The first capacitor terminal 31a and the second capacitor terminal 32a are both sheet-like, and in a thickness direction of the first capacitor terminal 31a, a projection of the second capacitor terminal 32a onto the first capacitor terminal 31a is at least partially accommodated within the first capacitor terminal 31a.

As shown in FIG. 4, the second functional module 20 includes a second body portion 21, the first terminal 31 disposed in the second functional module 20 is a first power terminal 31b, the second terminal 32 disposed in the second functional module 20 is a second power terminal 32b, and the first power terminal 31b and the second power terminal 32b are both electrically connected to an internal structure of the second body portion 21.

The first power terminal 31b and the second power terminal 32b are both sheet-like, and in a thickness direction of the first power terminal 31b, a projection of the second power terminal 32b onto the first power terminal 31b is at least partially accommodated within the first power terminal 31b.

The first terminal 31 and the second terminal 32 are both sheet-like. For ease of description, in FIG. 2 and subsequent figures, an extension direction of the first terminal 31 and the second terminal 32 is set as a first direction 001, a thickness direction of the first terminal 31 and the second terminal 32 is set as a second direction 002, and a width direction of the first terminal 31 and the second terminal 32 is set as a third direction 003.

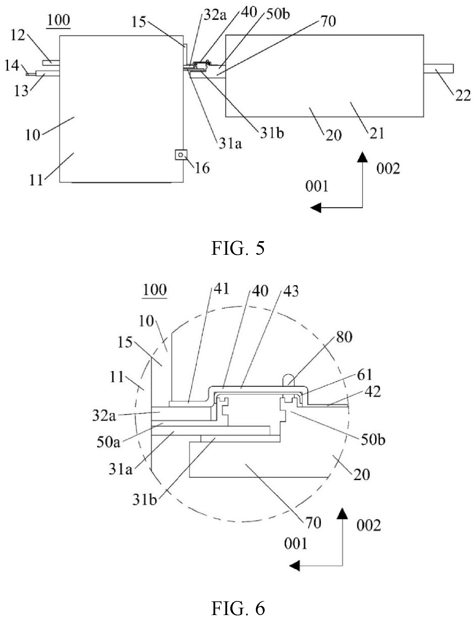

FIG. 5 is a diagram of a front view structure of an electronic device module according to an embodiment of the present disclosure. FIG. 6 is an enlarged diagram of an electronic device module according to an embodiment of the present disclosure.

As shown in FIG. 4 to FIG. 6, in the first direction 001, the first capacitor terminal 31a and the first power terminal 31b are located between the first body portion 11 and the second body portion 21, and a sum of lengths of the first capacitor terminal 31a and the first power terminal 31b is greater than a maximum separation distance between the first body portion 11 and the second body portion 21. This allows an end portion of the first capacitor terminal 31a to be lapped on an end portion of the first power terminal 31b, thereby electrically connecting the first capacitor terminal 31a and the second capacitor terminal 32a.

As shown in FIG. 4 to FIG. 6, in the first direction 001, the second capacitor terminal 32a and the second power terminal 32b are also located between the first body portion 11 and the second body portion 21, and a sum of lengths of the second capacitor terminal 32a and the second power terminal 32b is less than a separation distance between the first body portion 11 and the second body portion 21.

The electronic device module 100 of the present disclosure also includes a connector 40. The connector 40 is bridged between the second capacitor terminal 32a and the second power terminal 32b. This allows the second capacitor terminal 32a and the second power terminal 32b to be electrically connected via the connector 40.

The first capacitor terminal 31a may serve as a positive output terminal of the DC-link capacitor, and the second capacitor terminal 32a may serve as a negative output terminal of the DC-link capacitor. Correspondingly, the first power terminal 31b may serve as a positive input terminal of the power module, and the second power terminal 32b may serve as a negative input terminal of the power module.

That is, in the electronic device module 100 of the present disclosure, a current flow direction between the first capacitor terminal 31a and the first power terminal 31b is from the first capacitor terminal 31a to the first power terminal 31b. A current flow direction between the second capacitor terminal 32a and the second power terminal 32b is from the second power terminal 32b to the first power terminal 31b via the connector 40.

A flow direction of a current in a conductor is related to a direction of a magnetic field generated by the conductor, and generation of stray inductance is also related to changes in the magnetic field. It will be understood that the two first terminals 31 are electrically connected to each other, and the two second terminals 32 are electrically connected to each other. This allows a magnetic field generated by the current flowing in the two first terminals 31 and a magnetic field generated by the current flowing to the two second terminals 32 and the connector 40 to cancel each other, thereby reducing the generation of stray inductance.

Meanwhile, because the first terminal 31 and the second terminal 32 are both sheet-like, the magnetic field generated by the current in the first terminal 31 and the second terminal 32 is caused to extend in the third direction 003. It will be understood that, by configuring the projection of the second capacitor terminal 32a onto the first capacitor terminal 31to be at least partially accommodated within the first capacitor terminal 31a, and the projection of the second power terminal 32b onto the first power terminal 31b to be at least partially accommodated within the first power terminal 31b, an area of an overlapping region of the first terminal 31 and the second terminal 32 can be increased, and a spacing between the first terminal 31 and the second terminal 32 can be reduced, thereby reducing an equivalent inductance loop formed between the first terminal 31 and the second terminal 32.

A longer inductance loop indicates higher stray inductance generated correspondingly. The presence of stray inductance may cause problems such as a loss or signal attenuation in a circuit system. In a power module, stray inductance may increase a voltage fluctuation range, thereby causing damage to the power module. When the electronic device module 100 operates under a high-frequency condition, stray inductance also increase a switching loss of the power module.

Therefore, by electrically connecting the first terminals 31 of the first functional module 10 and the second functional module 20 to each other and electrically connecting the second terminals 32 of the first functional module 10 and the second functional module 20 to each other, and by configuring the projection of each second terminal 32 onto the first terminal 31 to be at least partially accommodated within the first terminal 31, the electronic device module 100 of the present disclosure can further prolong service life of the electronic device module 100 of the present disclosure whilst reducing the generation of stray inductance.

In another embodiment, the first capacitor terminal 31a may serve as a negative output terminal of the DC-link capacitor, and the second capacitor terminal 32a may serve as a positive output terminal of the DC-link capacitor. Correspondingly, the first power terminal 31b may serve as a negative input terminal of the power module, and the second power terminal 32b may serve as a positive input terminal of the power module.

In this case, the current flow direction between the first capacitor terminal 31a and the first power terminal 31b is still opposite to the current flow direction between the second capacitor terminal 32a and the second power terminal 32b. The magnetic field generated by the current in the two first terminals 31 and the magnetic field generated by the current in the two second terminals 32 can still cancel each other. This still has an effect of reducing the generation of stray inductance.

It will be understood that in some other embodiments, another structure may be used to achieve electrical connection between the second capacitor terminal 32a and the second power terminal 32b. This is not particularly limited in the present disclosure.

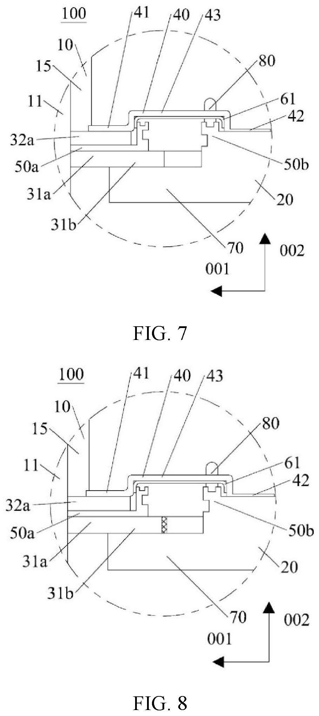

FIG. 7 is another enlarged diagram of an electronic device module according to an embodiment of the present disclosure.

As shown in FIG. 7, in the first direction 001, a sum of lengths of the first capacitor terminal 31a and the first power terminal 31b is equal to a maximum separation distance between the first body portion 11 and the second body portion 21. Correspondingly, the end portion of the first capacitor terminal 31a may be mutually abutted against the end portion of the first power terminal 31b to achieve electrical connection between the first capacitor terminal 31a and the first power terminal 31b.

FIG. 8 is still another enlarged diagram of an electronic device module according to an embodiment of the present disclosure.

As shown in FIG. 8, in the first direction 001, a sum of lengths of the first capacitor terminal 31a and the first power terminal 31b is less than a maximum separation distance between the first body portion 11 and the second body portion 21.

The sum of the lengths of the first capacitor terminal 31a and the first power terminal 31b is L1, the maximum separation distance between the first body portion 11 and the second body portion 21 is D1, and a thickness of the first terminal 31 is H1, where D1-L1≤H1/2. Correspondingly, the end portion of the first capacitor terminal 31a and the end portion of the first power terminal 31b are electrically connected by molten filling.

It will be understood that a condition D1-L1≤H1/2 is set to avoid difficulty in electrically connecting the first capacitor terminal 31a and the first power terminal 31b due to an excessive spacing between the first capacitor terminal 31a and the first power terminal 31b, thereby ensuring the electrical connection between the two first terminals 31.

In embodiments of the present disclosure and subsequent embodiments, electrical connection by lapping is characterized in that: two structures are spatially arranged in a staggered manner, with one structure placed on a surface of the other structure, so that there are overlapping regions between the two structures. Then, an electrical connection means is applied to the overlapping regions of the two structures, to connect the two structures into one integrated body.

For example, the first capacitor terminal 31a and the first power terminal 31b are electrically connected by lapping. To be specific, in the first direction 001, the first capacitor terminal 31a and the first power terminal 31b are disposed in a staggered manner, with a surface that is of the first capacitor terminal 31a and that faces the first power terminal 31b in contact with a surface of the first power terminal 31b that faces the first capacitor terminal 31a, so that there are overlapping regions between the first capacitor terminal 31a and the first power terminal 31b in the first direction 001. Then, the overlapping regions of the first capacitor terminal 31a and the first power terminal 31b are connected into one integrated body, to achieve the electrical connection by lapping between the first capacitor terminal 31a and the first power terminal 31b.

In embodiments of the present disclosure and subsequent embodiments, electrical connection by butting is characterized in that: two structures extend toward each other, with an end surface of each structure that faces the other structure in contact with the end surface of the other structure, and then the two structures are connected into one integrated body via an electrical connection means.

For example, the first capacitor terminal 31a and the first power terminal 31b are electrically connected by butting. To be specific, an end surface of the first capacitor terminal 31a that faces the second body portion 21 is in contact with an end surface of the first power terminal 31b that faces the first body portion 11, and the end surfaces that are of the first capacitor terminal 31a and the first power terminal 31b and that are in contact with each other are connected into an integrated body, thereby achieving the electrical connection by butting between the first capacitor terminal 31a and the first power terminal 31b.

In embodiments of the present disclosure and subsequent embodiments, electrical connection by molten filling is characterized in that: two structures extend toward each other, with an end surface of each structure that faces the other structure spaced apart from the end surface of the other structure, then a gap between the two end surfaces is filled with a meltable material, and the meltable material is melted via a corresponding electrical connection means, to achieve a purpose of connecting the two structures into one integrated body.

For example, the first capacitor terminal 31a and the first power terminal 31b electrically connected by molten filling. To be specific, an end surface of the first capacitor terminal 31a that faces the second body portion 21 is spaced apart from an end surface of the first power terminal 31b that faces the first body portion 11. In the first direction 001, a meltable material (not shown in the figure) is filled between the first capacitor terminal 31a and the first power terminal 31b. The meltable material is melted by a high temperature, to connect the meltable material to both the first capacitor terminal 31a and the first power terminal 31b, and to ensure that the meltable material fills a gap between the first capacitor terminal 31a and the first power terminal 31b, so that the first capacitor terminal 31a and the first power terminal 31b can be electrically connected under an action of the meltable material. The melt-filling and conduction between the first capacitor terminal 31a and the first power terminal 31b is achieved.

In an embodiment, the first capacitor terminal 31a and the first power terminal 31b are connected by using a non-contact energy source scanning connection technology. As shown in FIG. 4 to FIG. 6, a length of the first capacitor terminal 31a is greater than a length of the second capacitor terminal 32a, and a length of the first power terminal 31b is also greater than a length of the second power terminal 32b. That is, a portion of the first capacitor terminal 31a is exposed relative to the second capacitor terminal 32a, and a portion of the first power terminal 31b is also exposed relative to the second power terminal 32b.

As shown in FIG. 4 to FIG. 6, in the first direction 001, an overlapping portion of the first capacitor terminal 31a and the first power terminal 31b is located between the second capacitor terminal 32a and the second power terminal 32b, so that an external energy source can scan the overlapping portion of the first capacitor terminal 31a and the first power terminal 31b, and allow the overlapping portion of the first capacitor terminal 31a and the first power terminal 31b to be fused together, thereby achieving the electrical connection between the first capacitor terminal 31a and the first power terminal 31b.

It will be understood that the use of the non-contact energy source scanning connection technology to connect the two first terminals 31 in the electronic device module 100 of the present disclosure can prevent vibration from an external structure from affecting a connection effect during the connection process. Therefore, stability of the connection between the two first terminals 31 in the electronic device module 100 of the present disclosure is ensured.

In some other embodiments, the connection between the two first terminals 31 in the electronic device module 100 of the present disclosure may alternatively be implemented in another manner. This is not particularly limited in the present disclosure.

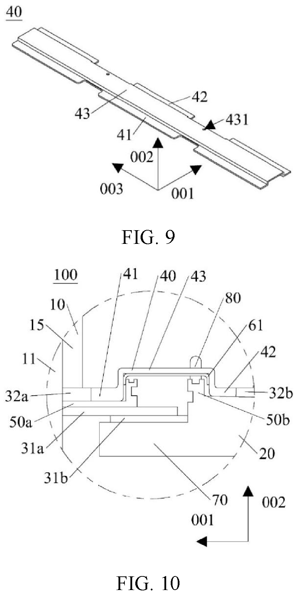

FIG. 9 is a diagram of a structure of a connector according to an embodiment of the present disclosure.

As shown in FIG. 2, FIG. 6, and FIG. 9, the connector 40 includes a connecting portion 43 and two abutment portions. The two abutment portions are respectively a first abutment portion 41 and a second abutment portion 42. In the first direction 001, the first abutment portion 41 and the second abutment portion 42 are located on two opposite sides of the connecting portion 43, and a sum of lengths of the first abutment portion 41, the second abutment portion 42 and the connecting portion 43 is greater than a maximum separation distance between the second capacitor terminal 32a and the second power terminal 32b.

The first abutment portion 41 is lapped on a surface of the second capacitor terminal 32a and electrically connected to the second capacitor terminal 32a, and the second abutment portion 42 is lapped on a surface of the second power terminal 32b and electrically connected to the second power terminal 32b. This implements the electrical connection between the second capacitor terminal 32a and the second power terminal 32b that are spaced apart from each other.

In an embodiment, as shown in FIG. 4 to FIG. 6, two opposite ends of the connector 40 are also connected by using a non-contact energy source scanning connection technology. It will be understood that the second capacitor terminal 32a and the second power terminal 32b extend beyond the corresponding lengths of the first body portion 11 and the second body portion 21, to facilitate scanning of lapped portions between the connector 40 and each of the second capacitor terminal 32a and the second power terminal 32b by an external energy source, thereby implementing the electrical connection between the second capacitor terminal 32a and the second power terminal 32b via the connector 40.

It will be understood that the use of the non-contact energy source scanning connection technology to connect the two second terminals 32 in the electronic device module 100 of the present disclosure can prevent vibration from an external structure from affecting a connection effect during the connection process. Therefore, stability of the connection between each second terminal 32 and the connector 40 in the electronic device module 100 of the present disclosure is ensured.

In some other embodiments, the connection between each second terminal 32 and the connector 40 in the electronic device module 100 of the present disclosure may alternatively be implemented in another manner. This is not particularly limited in the present disclosure.

FIG. 10 is a partially enlarged diagram of an electronic device module according to an embodiment of the present disclosure. To facilitate the description of a connection relationship between the second abutment portion 42 and the second power terminal 32b, some structures are omitted in FIG. 10.

As shown in FIG. 10, a sum of lengths of the first abutment portion 41, the second abutment portion 42, and the connecting portion 43 is equal to a maximum separation distance between the second capacitor terminal 32a and the second power terminal 32b.

An end portion of the first abutment portion 41 and an end portion of the second capacitor terminal 32a are electrically connected to each other by butting, and an end portion of the second abutment portion 42 and an end portion of the second power terminal 32b are electrically connected to each other by butting. This implements the electrical connection between the second capacitor terminal 32a and the second power terminal 32b that are spaced apart from each other.

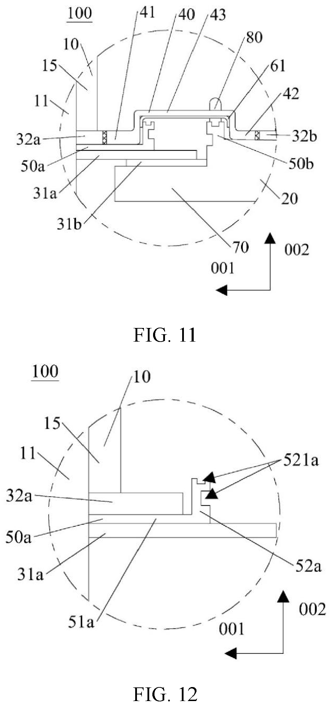

FIG. 11 is another partially enlarged diagram of an electronic device module according to an embodiment of the present disclosure. To facilitate the description of a connection relationship between the second abutment portion 42 and the second power terminal 32b, some structures are omitted in FIG. 11.

As shown in FIG. 11, a sum of lengths of the first abutment portion 41, the second abutment portion 42, and the connecting portion 43 is less than a maximum separation distance between the second capacitor terminal 32a and the second power terminal 32b.

The sum of the lengths of the first abutment portion 41, the second abutment portion 42, and the connecting portion 43 is L2, the maximum separation distance between the second capacitor terminal 32a and the second power terminal 32b is D2, and a thickness of the second terminal 32 is H2, where D2-L2<H2/2. Correspondingly, the end portion of the second capacitor terminal 32a and the end portion of the second power terminal 32b are electrically connected by molten filling.

It will be understood that a condition D2-L2≤H2/2 is set to avoid difficulty in electrically connecting the second capacitor terminal 32a and the second power terminal 32b due to an excessive spacing between the second capacitor terminal 32a and the second power terminal 32b, thereby ensuring the electrical connection between the two second terminals 32.

In an embodiment, as shown in FIG. 2, FIG. 6, and FIG. 9, a plurality of first abutment portions 41 are provided, and in the third direction 003, the first abutment portions 41 are spaced apart from each other and are sequentially connected to the connecting portion 43.

When the first abutment portion 41 and the second capacitor terminal 32a are connected, an external force needs to be applied to the first abutment portion 41 to deform the first abutment portion 41, thereby reducing a spacing between the first abutment portion 41 and the second capacitor terminal 32a in the second direction 002. It will be understood that providing the plurality of first abutment portions 41 can reduce stress concentration compared to using a single first abutment portion 41, thereby reducing difficulty of deforming each first abutment portion 41. This facilitates implementation of the electrical connection between the first abutment portion 41 and the second capacitor terminal 32a, thereby improving the connection stability of the electronic device module 100 of the present disclosure.

Meanwhile, a plurality of second abutment portions 42 are provided, and in the third direction 003, the second abutment portions 42 are spaced apart from each other and are sequentially connected to the connecting portion 43.

When the second abutment portion 42 and the second power terminal 32b are connected, an external force needs to be applied to the second abutment portion 42 to deform the second abutment portion 42, thereby reducing a spacing between the second abutment portion 42 and the second power terminal 32b in the second direction 002. It will be understood that providing the plurality of second abutment portions 42 can reduce stress concentration compared to using a single second abutment portion 42, thereby reducing difficulty of deforming each second abutment portion 42. This facilitates implementation of the electrical connection between the second abutment portion 42 and the second power terminal 32b, thereby improving the connection stability of the electronic device module 100 of the present disclosure.

In an embodiment, a quantity of the first abutment portion 41 is the same as a quantity of the second abutment portion 42, to facilitate manufacturing of the connector 40. It will be understood that, in some other embodiments, the quantity of the first abutment portion 41 may be different from the quantity of the second abutment portion 42. This is not particularly limited in the present disclosure.

In an embodiment, referring back to FIG. 3, FIG. 4, and FIG. 6. The first terminal 31 of each of the two functional modules includes a plurality of first sub-terminals 311. Specifically, in the first functional module 10, the first capacitor terminal 31a includes a plurality of first capacitor sub-terminals 311a, and in the third direction 003, the first capacitor sub-terminals 311a are spaced apart. In the second functional module 20, the first power terminal 31b includes a plurality of first power sub-terminals 311b, and in the third direction 003, the first power sub-terminals 311b are spaced apart.

The first power terminal 31b and the first capacitor terminal 31a are lap-connected to each other. In addition, when the first capacitor terminal 31a and the first power terminal 31b are connected, an external force also needs to be applied to the first power terminal 31b and the first capacitor terminal 31a to generate deformation, thereby reducing the spacing between the first power terminal 31b and the first capacitor terminal 31a.

It will be understood that, providing the plurality of first power sub-terminals 311b and the plurality of first capacitor sub-terminals 311a can reduce stress concentration of the first power terminal 31b and the first capacitor terminal 31a, thereby reducing difficulty of deforming each first power sub-terminal 311b and each first capacitor sub-terminal 311a. This facilitates implementation of the electrical connection between the first power sub-terminal 311b and the first capacitor sub-terminal 311a, thereby improving the connection stability of the electronic device module 100 of the present disclosure.

In an embodiment, in the second direction 002, in a lapped region of the first capacitor terminal 31a and the first power terminal 31b, a gap between the first capacitor terminal 31a and the first power terminal 31b is less than or equal to 0.2 mm. To ensure that during scanning of the lapped region by an energy source, the first capacitor terminal 31a and the first power terminal 31b that are molten can completely fill the gap, so that a full connection between the first capacitor terminal 31a and the first power terminal 31b is ensured, and phenomena such as blowholes and poor soldering are avoided, thereby ensuring the connection stability of the electronic device module 100 of the present disclosure.

In an embodiment, in the second direction 002, in a lapped region of the first abutment portion 41 and the second capacitor terminal 32a, a gap between the first abutment portion 41 and the second capacitor terminal 32a is less than or equal to 0.2 mm. In a lapped region between the second abutment portion 42 and the second power terminal 32b, a gap between the second abutment portion 42 and the second power terminal 32b is less than or equal to 0.2mm. This ensures a full connection between the first abutment portion 41 and the second capacitor terminal 32a, and between the second abutment portion 42 and the second power terminal 32b, thereby ensuring the connection stability of the electronic device module 100 of the present disclosure.

In an embodiment, as shown in FIG. 3, FIG. 4, and FIG. 6, a quantity of the first power sub-terminals 311b is the same as a quantity of the first capacitor sub-terminals 311a, and each first capacitor sub-terminal 311a is caused to be electrically connected by lapping to one first power sub-terminal 311b.

It will be understood that, in some other embodiments, because the first capacitor terminal 31a is lapped on the first power terminal 31b, the quantity of the first capacitor sub-terminals 311a may be greater than the quantity of the first power sub-terminals 311b, and there may be a case in which a plurality of first capacitor sub-terminals 311a are lapped on one first power sub-terminal 311b. In some other embodiments, the first capacitor sub-terminals 311a and the first power sub-terminals 311b may be provided in other quantities.

In an embodiment, for the first functional module 10, in the third direction 003, a ratio of a width of the first capacitor terminal 31a to a width of the second capacitor terminal 32a is between 0.8 and 1.2. When the ratio of the width of the first capacitor terminal 31a to the width of the second capacitor terminal 32a is less than 0.8, the projection of the second capacitor terminal 32a onto the first capacitor terminal 31a does not increase within a region of the first capacitor terminal 31a. As a result, a portion of the magnetic field generated by the first capacitor terminal 31a cannot be canceled by the magnetic field generated by the second capacitor terminal 32a, and the magnetic field generated by the second capacitor terminal 32a cannot be oppositely canceled by the magnetic field generated by the first capacitor terminal 31a. This results in stray inductance.

When the ratio of the width of the first capacitor terminal 31a to the width of the second capacitor terminal 32a is greater than 1.2, a projection of the first capacitor terminal 31a onto the second capacitor terminal 32a does not increase within a region of the second capacitor terminal 32a. As a result, a portion of the magnetic field generated by the second capacitor terminal 32a cannot be effectively and oppositely canceled by the magnetic field generated by the first capacitor terminal 31a, and the magnetic field generated by the first capacitor terminal 31a cannot be oppositely canceled by the magnetic field generated by the second capacitor terminal 32a. This results in stray inductance.

That is, setting the ratio of the width of the first capacitor terminal 31a to the width of the second capacitor terminal 32a to be between 0.8 and 1.2 can increase a cancellation ratio between the magnetic field generated by the current in the first capacitor terminal 31a and the magnetic field generated by the current in the second capacitor terminal 32a, thereby further ensuring the effect of reducing stray inductance of the electronic device module 100 of the present disclosure.

In an embodiment, the ratio of the width of the first capacitor terminal 31a to the width of the second capacitor terminal 32a is 1, and the first capacitor terminal 31a and the second capacitor terminal 32a are aligned with each other.

In an embodiment, for the second functional module 20, in the third direction 003, a ratio of a width of the first power terminal 31b to a width of the second power terminal 32b is between 0.8 and 1.2. When the ratio of the width of the first power terminal 31b to the width of the second power terminal 32b is less than 0.8, the projection of the second power terminal 32b onto the first power terminal 31b does not increase within a region of the first power terminal 31b. As a result, a portion of the magnetic field generated by the first power terminal 31b cannot be canceled by the magnetic field generated by the second power terminal 32b, and the magnetic field generated by the second power terminal 32b cannot be oppositely canceled by the magnetic field generated by the first power terminal 31b. This results in stray inductance.

When the ratio of the width of the first power terminal 31b to the width of the second power terminal 32b is greater than 1.2, a projection of the first power terminal 31b onto the second power terminal 32b does not increase within a region of the second power terminal 32b. As a result, a portion of the magnetic field generated by the second power terminal 32b cannot be canceled by the magnetic field generated by the first power terminal 31b, and the magnetic field generated by the first power terminal 31b cannot be oppositely canceled by the magnetic field generated by the second power terminal 32b. This results in stray inductance.

That is, setting the ratio of the width of the first power terminal 31b to the width of the second power terminal 32b to be between 0.8 and 1.2 can increase a cancellation ratio between the magnetic field generated by the current in the first power terminal 31b and the magnetic field generated by the current in the second power terminal 32b, thereby further ensuring the effect of reducing stray inductance of the electronic device module 100 of the present disclosure.

In an embodiment, the ratio of the width of the first power terminal 31b to the width of the second power terminal 32b is 1, and the first power terminal 31b and the second power terminal 32b are aligned with each other.

In an embodiment, the electronic device module 100 of the present disclosure further includes two insulating members 50, and the two insulating members 50 are respectively a capacitor insulating member 50a and a power insulating member 50b.

Specifically, FIG. 12 is an enlarged diagram of a first functional module of an electronic device module according to an embodiment of the present disclosure.

As shown in FIG. 3 and FIG. 12, the capacitor insulating member 50a is fastened between the first capacitor terminal 31a and the second capacitor terminal 32a, and is in contact with the first capacitor terminal 31a and the second capacitor terminal 32a. In the first direction 001, an extension length of the capacitor insulating member 50a is between an extension length of the first capacitor terminal 31a and an extension length of the second capacitor terminal 32a.

It will be understood that the provision of the capacitor insulating member 50a can prevent voltage breakdown of a gap between the first capacitor terminal 31a and the second capacitor terminal 32a, and prevent a short circuit caused by the first capacitor terminal 31a and the second capacitor terminal 32a being too close in the second direction 002, thereby protecting use safety of the electronic device module 100 of the present disclosure.

Meanwhile, the provision of capacitor insulating member 50a can also reduce a spacing between the first capacitor terminal 31a and the second capacitor terminal 32a while ensuring a safe distance between the first capacitor terminal 31a and the second capacitor terminal 32a in the second direction 002, thereby reducing an inductance loop of the electronic device module 100 of the present disclosure, and thus reducing the stray inductance of the electronic device module 100 of the present disclosure.

In an embodiment, as shown in FIG. 3 and FIG. 12, the capacitor insulating member 50a includes a first insulating portion 51a and a first insulating protrusion 52a. The first insulating portion 51a is disposed between the first capacitor terminal 31a and the second capacitor terminal 32a. The first insulating protrusion 52a is provided on an end portion of the first insulating portion 51a. The first insulating protrusion 52a is exposed on a surface of the second capacitor terminal 32a and extends in a direction away from the first capacitor terminal 31a in the second direction 002. In the second direction 002, the first insulating protrusion 52a is spaced apart from the connector 40.

It will be understood that the provision of the first insulating protrusion 52a increases a creepage distance between the end portion of the second capacitor terminal 32a and the first capacitor terminal 31a, to prevent a phenomenon in which a current at the end portion of the second capacitor terminal 32a extends directly along a surface of the capacitor insulating member 50a and connects with a current of the first capacitor terminal 31a. This increases the creepage distance between the first capacitor terminal 31a and the second capacitor terminal 32a while reducing the spacing between the first capacitor terminal 31a and the second capacitor terminal 32a in the second direction 002, thereby further ensuring the use safety of the electronic device module 100 of the present disclosure, and further reducing the generation of stray inductance.

In an embodiment, as shown in FIG. 3 and FIG. 12, a surface of the first insulating protrusion 52a that is away from the first capacitor terminal 31a is provided with a first groove 521a, and a surface of the first insulating protrusion 52a that is away from the second capacitor terminal 32a is also provided with a first groove 521a. It will be understood that the provision of the first groove 521a further increases the creepage distance between the first capacitor terminal 31a and the second capacitor terminal 32a, thereby further ensuring the use safety of the electronic device module 100 of the present disclosure, and further reducing the generation of stray inductance.

In an embodiment, there may be a plurality of first grooves 521a. In another embodiment, the first groove 521a may alternatively be provided only on the surface of the first insulating protrusion 52a that is away from the first capacitor terminal 31a or on the surface of the first insulating protrusion 52a that is away from the second capacitor terminal 32a. This is not particularly limited in the present disclosure.

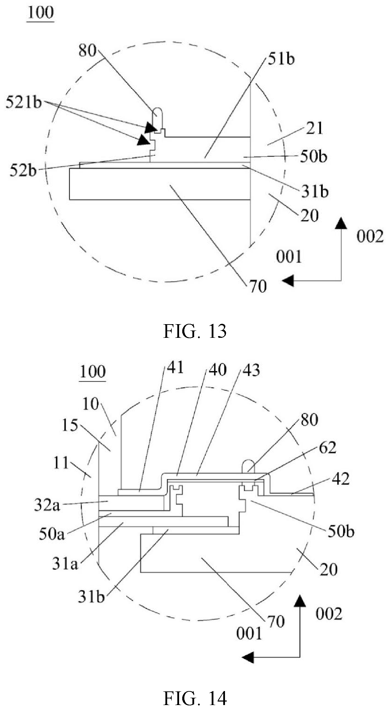

FIG. 13 is an enlarged diagram of a second functional module of an electronic device module according to an embodiment of the present disclosure.

As shown in FIG. 4 and FIG. 13, the power insulating member 50b is fastened between the first power terminal 31b and the second power terminal 32b, and is in contact with the first power terminal 31b and the second power terminal 32b. In the first direction 001, an extension length of the power insulating member 50b is between an extension length of the first capacitor terminal 31a and an extension length of the second capacitor terminal 32a.

It will be understood that the provision of the power insulating member 50b can prevent voltage breakdown of a gap between the first power terminal 31b and the second power terminal 32b, and prevent a short circuit caused by the first power terminal 31b and the second power terminal 32b being too close in the second direction 002, thereby protecting use safety of the electronic device module 100 of the present disclosure.

Meanwhile, the provision of the power insulating member 50b can also reduce a spacing between the first power terminal 31b and the second power terminal 32b while ensuring a safe distance between the first power terminal 31b and the second power terminal 32b in the second direction 002, thereby reducing an inductance loop of the electronic device module 100 of the present disclosure, and thus reducing the stray inductance of the electronic device module 100 of the present disclosure.

In an embodiment, as shown in FIG. 4 and FIG. 13, the power insulating member 50b includes a second insulating portion 51b and a second insulating protrusion 52b. The second insulating portion 51b is disposed between the first power terminal 31b and the second power terminal 32b. The second insulating protrusion 52b is provided on an end portion of the second insulating portion 51b. The second insulating protrusion 52b is exposed on a surface of the second power terminal 32b and extends in a direction away from the first power terminal 31b in the second direction 002. In the second direction 002, the second insulating protrusion 52b is spaced apart from the connector 40.

It will be understood that the provision of the second insulating protrusion 52b increases a creepage distance between the end portion of the second power terminal 32b and the first power terminal 31b, to prevent a phenomenon in which a current at the end portion of the second power terminal 32b extends directly along a surface of the power insulating member 50b and connects with a current of the first power terminal 31b. This increases the creepage distance between the first power terminal 31b and the second power terminal 32b while reducing the spacing between the first power terminal 31b and the second power terminal 32b in the second direction 002, thereby further ensuring the use safety of the electronic device module 100 of the present disclosure, and further reducing the generation of stray inductance.

In an embodiment, as shown in FIG. 4 and FIG. 13, a surface of the second insulating protrusion 52b that is away from the first power terminal 31b is provided with a second groove 521b, and a surface of the second insulating protrusion 52b that is away from the second power terminal 32b is also provided with a second groove 521b. It will be understood that the provision of the second groove 521b further increases the creepage distance between the first power terminal 31b and the second power terminal 32b, thereby further ensuring the use safety of the electronic device module 100 of the present disclosure, and further reducing the generation of stray inductance.

In an embodiment, there may be a plurality of second grooves 521b. In another embodiment, the second groove 521b may alternatively be provided only on the surface of the second insulating protrusion 52b that is away from the first power terminal 31b or on the surface of the second insulating protrusion 52b that is away from the second power terminal 32b. This is not particularly limited in the present disclosure.

In an embodiment, as shown in FIG. 2 and FIG. 6, the electronic device module 100 of the present disclosure further includes a second insulating member 61, and the second insulating member 61 is fastened to a surface of the connecting portion 43 that faces the first terminal 31. Because flow directions of the currents in the first terminal 31 and the second terminal 32 are different, and the connector 40 is electrically connected to the second terminal 32, it will be understood that the provision of the second insulating member 61 can prevent voltage breakdown of a gap between the connecting portion 43 and the first terminal 31, and prevent a short circuit caused by the connecting portion 43 and the first terminal 31 being too close in the second direction 002, thereby protecting use safety of the electronic device module 100 of the present disclosure.

Meanwhile, the provision of the second insulating member 61 can also reduce a spacing between the connecting portion 43 and the first terminal 31 while ensuring a safe distance between the connecting portion 43 and the first terminal 31 in the second direction 002, thereby reducing an inductance loop of the electronic device module 100 of the present disclosure, allowing magnetic fields respectively generated by the connecting portion 43 and the first terminal 31 to cancel each other to a greater extent, and thus reducing the stray inductance of the electronic device module 100 of the present disclosure.

In an embodiment, as shown in FIG. 2 and FIG. 6, in the first direction 001, a length of the second insulating member 61 is greater than or equal to a spacing between the capacitor insulating member 50a and the power insulating member 50b. This allows the second insulating member 61 to cooperate with the capacitor insulating member 50a and the power insulating member 50b, to further prevent voltage breakdown of the gap between the connecting portion 43 and the first terminal 31, thereby further protecting the use safety of the electronic device module 100 of the present disclosure.

Meanwhile, the spacing between the connecting portion 43 and the first terminal 31 can also be further reduced, to further reduce the inductance loop of the electronic device module 100 of the present disclosure, and thus further reduce the stray inductance of the electronic device module 100 of the present disclosure.

In an embodiment, as shown in FIG. 2 and FIG. 6, in the third direction 003, a width of the second insulating member 61 is greater than or equal to a width of the connector 40. That is, in the third direction 003, two opposite ends of the second insulating member 61 extend out of end surfaces of the connector 40, to further prevent voltage breakdown of the gap between the connecting portion 43 and the first terminal 31, thereby further protecting the use safety of the electronic device module 100 of the present disclosure.

FIG. 14 is still another partially enlarged diagram of an electronic device module according to an embodiment of the present disclosure.

As shown in FIG. 14, the electronic device module 100 of the present disclosure further includes an insulating layer 62, and the insulating layer 62 is coated on a surface of the connecting portion 43 that faces the first terminal 31. It will be understood that the provision of the insulating layer 62 can prevent voltage breakdown of a gap between the connecting portion 43 and the first terminal 31, and prevent a short circuit caused by the connecting portion 43 and the first terminal 31 being too close in the second direction 002, thereby protecting use safety of the electronic device module 100 of the present disclosure.

Meanwhile, the provision of the insulating layer 62 can also reduce a spacing between the connecting portion 43 and the first terminal 31 while ensuring a safe distance between the connecting portion 43 and the first terminal 31 in the second direction 002, thereby reducing an inductance loop of the electronic device module 100 of the present disclosure, allowing magnetic fields respectively generated by the connecting portion 43 and the first terminal 31 to cancel each other to a greater extent, and thus reducing the stray inductance of the electronic device module 100 of the present disclosure.

In an embodiment, as shown in FIG. 6 and FIG. 13, the electronic device module 100 of the present disclosure further includes a support member 70. The support member 70 is disposed on a side of the first power terminal 31b that is away from the second power terminal 32b, to support the first power terminal 31b and the first capacitor terminal 31a lapped on the first power terminal 31b.

In an embodiment, as shown in FIG. 4, FIG. 6, and FIG. 10, in the third direction 003, portions of the support member 70 on two opposite sides thereof extend along two opposite side surfaces of the first power terminal 31b and are integrally connected to the power insulating member 50b.

It will be understood that, in some other embodiments, when the first power terminal 31b is lapped on the first capacitor terminal 31a, the support member 70 is disposed on a side of the first capacitor terminal 31a that is away from the second capacitor terminal 32a, to support the first capacitor terminal 31a and the first power terminal 31b.

In an embodiment, referring back to FIG. 2, FIG. 7, and FIG. 10. The electronic device module 100 of the present disclosure further includes a positioning post 80, a positioning hole 431 is provided in the connecting portion 43, and a quantity of the positioning hole 431 is equal to a quantity of the positioning post 80. The positioning post 80 is disposed on the second groove 521b. When the connector 40 is connected to the second capacitor terminal 32a and the second power terminal 32b, the positioning post 80 can extend into the positioning hole 431, to implement positioning of the connector 40.

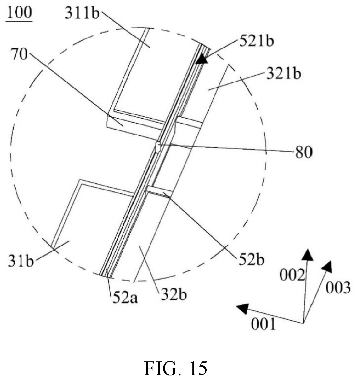

FIG. 15 is another enlarged diagram of a second functional module of an electronic device module according to an embodiment of the present disclosure.

As shown in FIG. 4 and FIG. 15, the first power terminal 31b includes a plurality of first power sub-terminals 311b, and the second power terminal 32b includes a plurality of second power sub-terminals 321b. In the third direction 003, the plurality of first power sub-terminals 311b and the plurality of second power sub-terminals 321b are spaced apart from each other, and a quantity of the first power sub-terminals 311b is equal to a quantity of the second power sub-terminals 321b.

As shown in FIG. 4 and FIG. 15, a plurality of positioning posts 80 are provided, each being spaced apart between two adjacent first power sub-terminals 311b, and each positioning post 80 is also disposed between two adjacent second power sub-terminals 321b, to prevent the positioning post 80 from damaging a creepage distance between the first power sub-terminal 311b and the second power sub-terminal 321b, thereby further ensuring the use safety of the electronic device module 100 of the present disclosure.

Meanwhile, the cooperation of the plurality of positioning posts 80 with the positioning holes 431 in the connecting portion 43 can further implement positioning of the connector 40, to avoid positional deviation of the connector 40 during the connection process that may otherwise affect connection reliability between the connector 40 and the second terminal 32, thereby improving the connection reliability of the electronic device module 100 of the present disclosure.

In another embodiment, the positioning post 80 may alternatively be disposed on the first groove 521a of the first insulating protrusion 52a. Correspondingly, the second capacitor terminal 32a also includes a plurality of second capacitor sub-terminals (not shown in the figure), to prevent the positioning post 80 from damaging the creepage distance between the first capacitor terminal 31a and the second capacitor terminal 32a.

In an embodiment, as shown in FIG. 2 to FIG. 4, in the third direction 003, widths of the first capacitor sub-terminal 311a and the first power sub-terminal 311b that are located on two opposite sides of the first body portion 11 are greater than widths of the remaining first capacitor sub-terminals 311a and the remaining first power sub-terminals 311b.

During the operation of the controller of the present disclosure, there is a cooling pipe that passes through a portion between the first body portion 11 and the second body portion 21 in the third direction 003. Along a flow direction of a coolant in the cooling pipe, a temperature of the coolant gradually increases, and a heat absorption capacity gradually decreases. It will be understood that widening the first capacitor sub-terminals 311a and the first power sub-terminals 311b that are on the two opposite sides of the first body portion 11 can reduce overall resistance of the first capacitor sub-terminals 311a and the first power sub-terminals 311b in this portion, thereby reducing heat generated by the first capacitor sub-terminals 311a and the first power sub-terminals 311b. In coordination with the flow direction of the cooling pipe, this enhances the temperature uniformity effect of the electronic device module 100 of the present disclosure.

In an embodiment, as shown in FIG. 2 to FIG. 4, the width of the first capacitor terminal 31a lapped on the first power terminal 31b is greater than or equal to the width of the lapped first power terminal 31b, to ensure a lapping width between the first power terminal 31b and the first capacitor terminal 31a, thereby ensuring an overcurrent capability of the electronic device module 100 of the present disclosure.

In an embodiment, a material of the first insulating protrusion 52a, the second insulating protrusion 52b, and the positioning post 80 is white or another light color close to white. According to the electronic device module 100 of the present disclosure, when the non-contact energy source scanning connection technology is used for connection, the energy source can be absorbed by a dark-colored material. It will be understood that, making the material of the first insulating protrusion 52a, the second insulating protrusion 52b, and the positioning post 80 white or another light color close to white can reduce heat absorbed by the energy source during scanning, thereby avoiding damage to these components caused by excessive heat. This ensures structural stability and electrical insulation safety of the first insulating protrusion 52a, the second insulating protrusion 52b, and the positioning post 80.

In an embodiment, as shown in FIG. 3, the first functional module 10 further includes a first input terminal 12 and a second input terminal 13. The first input terminal 12 and the second input terminal 13 are located on a side of the first body portion 11 that is away from the first terminal 31 and the second terminal 32. The first input terminal 12 is connected to a negative electrode of an external battery pack, and the second input terminal 13 is connected to a positive electrode of the external battery pack. The first input terminal 12 and the second input terminal 13 provide power to the first functional module 10.

In an embodiment, as shown in FIG. 3, the first functional module 10 further includes a first boost terminal 14 and a second boost terminal 15. The first boost terminal 14 is located on the same side as the first input terminal 12 and the second input terminal 13. The second boost terminal 15 is located on a side wall of the first body portion 11, and is connected to an internal structure of the first body portion 11 via a surface of the first body portion 11 on which the first terminal 31 is provided.

The first boost terminal 14 and the second boost terminal 15 are connected to a boost capacitor (not shown in the figure) accommodated within the first body portion 11, and are connected to an external boost circuit, to boost a voltage input to the battery pack from an external power supply.

In an embodiment, as shown in FIG. 3, the first functional module 10 further includes a grounding terminal 16. The grounding terminal 16 is located on a side wall of the first body portion 11, and is disposed opposite to the second boost terminal 15. The grounding terminal 16 is also connected to the internal structure of the first body portion 11 via the surface of the first body portion 11 on which the first terminal 31 is provided. The grounding terminal 16 is configured to connect to a ground structure, to protect use safety of the first functional module 10 and improve the anti-interference capability of the first functional module 10.

In an embodiment, as shown in FIG. 4, the second functional module 20 further includes three-phase output terminals 22 provided in a quantity of three, and the three-phase output terminals 22 are spaced apart on a surface of the second body portion 21 that is away from the first terminal 31, to output a three-phase current to the outside.

It will be understood that the terms "first", "second", and the like are merely intended for a purpose of description, and will not be understood as an indication or implication of relative importance or implicit indication of a quantity of indicated technical features. Therefore, a feature limited by "first" or "second" may explicitly or implicitly include one or more features. In the descriptions of implementations of the present disclosure, unless otherwise specifically limited, "a plurality of" means two or more.

In the descriptions of this specification, descriptions with reference to terms such as "one implementation", "some implementations", "illustrative implementation", "example", "specific example", or "some examples" mean that specific features, structures, materials, or characteristics described with reference to the implementation or example are included in at least one implementation or example of the present disclosure. In this specification, illustrative expressions of the foregoing terms do not necessarily refer to the same implementation or example. Moreover, the specific features, structures, materials, or characteristics described may be combined in a proper manner in any one or more implementations or examples.

It will be understood that the application of the present disclosure is not limited to the examples above. A person of ordinary skill in the art may make improvements or modifications based on the foregoing descriptions, and all these improvements and modifications should fall within the protection scope of the appended claims of the present disclosure. A person of ordinary skill in the art may understand that all or some of the procedures for implementing the foregoing embodiments and equivalent modifications made in accordance with the claims of the present invention still fall within the scope of the present invention.

## Claims

1. An electronic device module (100), comprising two functional modules;
each of the functional modules is provided with a first terminal (31) and a second terminal (32), the first terminal (31) and the second terminal (32) both extend toward the other functional module, end portions of the two first terminals (31) of the two functional modules are electrically connected, and end portions of the two second terminals (32) of the two functional modules are electrically connected; and
in a thickness direction of the first terminal (31), a projection of the second terminal (32) onto the first terminal (31) is at least partially accommodated within the first terminal (31).

2. The electronic device module (100) according to claim 1, wherein a sum of lengths of the two first terminals (31) of the two functional modules is greater than or equal to a maximum separation distance between the two functional modules, and the end portions of the two first terminals (31) of the two functional modules are electrically connected by lapping.

3. The electronic device module (100) according to claim 1, wherein a sum of lengths of the two first terminals (31) of the two functional modules is L1, a maximum separation distance between the two functional modules is D1, and a thickness of the first terminal (31) of each of the functional modules is H1, wherein L1<D1, and D1-L1≤H1/2; and
the end portions of the two first terminals (31) of the two functional modules are electrically connected by molten filling.

4. The electronic device module (100) according to claim 1, wherein the electronic device module (100) further comprises a connector (40), the end portions of the two second terminals (32) of the two functional modules are electrically connected via the connector (40), the connector (40) comprises a connecting portion (43) and two abutment portions (41, 42), the connecting portion (43) is located between the two abutment portions (41, 42), and each of the abutment portions (41, 42) is electrically connected to one of the second terminals (32).

5. The electronic device module (100) according to claim 4, wherein a sum of lengths of the connecting portion (43) and the two abutment portions (41, 42) is greater than or equal to a maximum separation distance between the two second terminals (32) of the two functional modules, and each of the abutment portions (41, 42) is electrically connected by lapping to the second terminal (32) of one of the functional modules.

6. The electronic device module (100) according to claim 4, wherein a sum of lengths of the connecting portion (43) and the two abutment portions (41, 42) is L2, a maximum separation distance between the two second terminals (32) of the two functional modules is D2, and a thickness of the second terminal (32) of each of the functional modules is H2, wherein L2<D2, and D2-L2<H2/2; and
each of the abutment portions (41, 42) is electrically connected by molten filling to the second terminal (32) of one of the functional modules.

7. The electronic device module (100) according to any one of claims 4 to 6, wherein the first terminal (31) of at least one of the functional modules comprises a plurality of first sub-terminals (311), and the first sub-terminals (311) are spaced apart in a width direction of the first terminal (31); and/or
the second terminal (32) of at least one of the functional modules comprises a plurality of second sub-terminals (321), and the second sub-terminals (321) are spaced apart in a width direction of the second terminal (32).

8. The electronic device module (100) according to any one of claims 4 to 6, wherein the first terminal (31) of at least one of the functional modules comprises a plurality of first sub-terminals (311), and in a width direction of the first terminal (31), a width of the first sub-terminal (311) located at an edge among the plurality of first sub-terminals (311) is greater than a width of the remaining first sub-terminals (311).

9. The electronic device module (100) according to any one of claims 4 to 6, wherein for the same functional module, the first terminal (31) comprises a plurality of first sub-terminals (311), the second terminal (32) comprises a plurality of second sub-terminals (321), a quantity of the first sub-terminals (311) is equal to a quantity of the second sub-terminals (321), and in the thickness direction of the first terminal (31), a projection of each of the second sub-terminals (321) onto the first sub-terminal (311) is at least partially accommodated within one of the first sub-terminals (311).

10. The electronic device module (100) according to any one of claims 4 to 6, wherein a ratio of a width of the first terminal (31) to a width of the second terminal (32) is between 0.8 and 1.2.

11. The electronic device module (100) according to any one of claims 4 to 6, wherein the electronic device module (100) further comprises two insulating members (50), each of the insulating members (50) is fastened between the first terminal (31) and the second terminal (32) of one of the functional modules and extends toward the other functional module, and an extension length of each of the insulating members (50) is between an extension length of the first terminal (31) and an extension length of the second terminal (32).

12. The electronic device module (100) according to claim 11, wherein the electronic device module (100) further comprises a second insulating member (61), the second insulating member (61) is disposed on a surface of the connector (40) that faces the first terminal (31), and in the thickness direction of the first terminal (31), a projection of the second insulating member (61) onto the first terminal (31) covers the first terminal (31) exposed between the two second terminals (32) of the two functional modules;
in a length direction of the first terminal (31), a length of the second insulating member (61) is greater than or equal to a spacing between the two insulating members (50) of the two functional modules; and
in a width direction of the first terminal (31), a width of the second insulating member (61) is greater than or equal to a width of the connector (40).

13. The electronic device module (100) according to claim 11, wherein the electronic device module (100) further comprises an insulating layer (62), the insulating layer (62) is coated on a surface of the connector (40) that faces the first terminal (31), and in the thickness direction of the first terminal (31), a projection of the first terminal (31) exposed between the two second terminals (32) of the two functional modules onto the insulating layer (62) is accommodated within the insulating layer (62); and
in a length direction of the first terminal (31), a length of the insulating layer (62) is greater than or equal to a spacing between the two insulating members (50) of the two functional modules.

14. The electronic device module (100) according to claim 11, wherein at least one of the insulating members (50) is provided with insulating protrusions (52a, 52b), the insulating protrusions (52a, 52b) are exposed between the second terminals (32) of the two functional modules and extend in a direction away from the first terminal (31), and the insulating protrusions (52a, 52b) are spaced apart from the connector (40).

15. The electronic device module (100) according to claim 14, wherein at least one groove is provided on a surface of the insulating protrusions (52a, 52b) that is away from the first terminal (31); and/or
at least one groove is provided on a surface of the insulating protrusions (52a, 52b) that is away from the second terminal (32).

16. The electronic device module (100) according to claim 14, wherein a surface of the insulating protrusions (52a, 52b) that is away from the first terminal (31) is provided with a positioning post (80) in a protruding manner, and in a width direction of the first terminal (31), the positioning post (80) is spaced apart from the first terminal (31) and the second terminal (32); and
a positioning hole (431) is provided in the connector (40), and the positioning post (80) is configured to extend into the positioning hole (431) to implement positioning of the connector (40).

17. The electronic device module (100) according to any one of claims 4 to 6, wherein the end portions of the first terminals (31) of the two functional modules are electrically connected by using a non-contact energy source scanning connection technology; and
in the thickness direction of the first terminal (31), a spacing between the end portions of the first terminals (31) of the two functional modules is less than or equal to 0.2 mm.

18. The electronic device module (100) according to any one of claims 4 to 6, wherein the end portion of the second terminal (32) of at least one of the functional modules is electrically connected to the connector (40) by using a non-contact energy source scanning connection technology; and
in a thickness direction of the second terminal (32), a spacing between the end portion of the second terminal (32) that is electrically connected to the connector (40) by using the non-contact energy source scanning connection technology is less than or equal to 0.2 mm.

19. A controller (200), comprising the electronic device module (100) according to any one of claims 1 to 18, and two functional modules of the electronic device module (100) are respectively a DC-link capacitor and a power module.

20. A vehicle (300), comprising the controller (200) according to claim 19.
